# EUROPEAN PATENT SPECIFICATION

(11) **EP 4 435 451 B1**
(45) Date of publication and mention of the grant of the patent: **25.02.2026**
(21) Application number: 23816236.6
(22) Date of filing: 04.05.2023
(51) Int. Cl.: G01R 31/367, G01R 31/396, G01R 31/36, G01R 31/392, G01R 31/374, G01R 19/00, G01R 19/165

(54) **APPARATUS AND METHOD FOR DIAGNOSING ABNORMALITY OF BATTERY CELL**
VORRICHTUNG UND VERFAHREN ZUR DIAGNOSE VON ANOMALIEN EINER BATTERIEZELLE
APPAREIL ET PROCÉDÉ DE DIAGNOSTIC D'ANOMALIE D'ÉLÉMENT DE BATTERIE

(30) Priority: 31.05.2022 KR 20220066469; 28.04.2023 KR 20230055940
(43) Date of publication of application: 25.09.2024
(73) Proprietor: LG Energy Solution, Ltd., Seoul 07335 (KR)
(72) Inventor: KIM, Changhoon, Daejeon 34122 (KR)
(74) Representative: Plasseraud IP
(86) International application number: PCT/KR2023/006110
(87) International publication number: WO 2023/234572

(56) References cited:
- KR-A- 20160 085 070
- KR-A- 20200 070 122
- KR-A- 20220 068 806
- KR-B1- 101 599 998
- KR-B1- 101 599 998
- US-A1- 2005 218 915
- US-A1- 2010 246 653

## Description

### [Technical Field]

This application claims priority to and the benefit of Korean Patent Application No.10-2022-0066469 filed in the Korean Intellectual Property Office on May 31, 2022 and Korean Patent Application No.10-2023-0055940 filed in the Korean Intellectual Property Office on April 28, 2023.

The present invention relates to an apparatus and method for diagnosing an abnormality of a battery cell, and more particularly to an apparatus and method for diagnosing an abnormality of a battery cell, by obtaining measurement data from a battery cell and applying diagnostic data generated based thereon to a diagnosis algorithm.

### [Background Art]

Recently, due to depletion of fossil energy and environmental pollution, interest in electric vehicles using electric energy without using fossil energy is increasing.

In general, an electric vehicle operates a drive motor that requires high output for driving. Accordingly, an electric vehicle uses a battery pack in which a plurality of battery cells are connected in series and uses electricity output from the battery pack as an energy source.

Here, since hundreds of cells are connected in series in a battery pack, an accumulated voltage thereof may vary depending on a voltage measurement method. Thus, in order to accurately measure the voltage of the battery pack for an electric vehicle, the voltage of each cell unit must be accurately measured.

However, the battery pack for an electric vehicle has a disadvantage in that it is difficult to precisely measure the cell voltage because a number of noise signals are generated when measuring the voltage of the battery cell due to movement of the electric vehicle or surrounding environment.

KR 101599998 B1 relates to to compression of voltage data of a battery pack for storage of the data.

US2010/246653 relates to a general-purpose amplitude probability distribution measurement apparatus capable of changing a measurement condition, such as the number of channels or a resolution bandwidth.

### [Detailed Description of the Invention]

### [Technical Problem]

To obviate one or more problems of the related art, embodiments of the present disclosure provide an apparatus for diagnosing an abnormality of a battery cell with high precision and high reliability.

To obviate one or more problems of the related art, embodiments of the present disclosure also provide a method for diagnosing an abnormality of a battery cell with high precision and high reliability.

### [Technical Solution]

In order to achieve the objective of the present disclosure, a method of diagnosing an abnormality according to claim 1 is provided in a first aspect.

The method of diagnosing an abnormality of a battery cell may further include correcting the generated diagnostic data using a low pass filter (LPF).

The determining whether the battery cell has an abnormality may include determining whether the battery cell is abnormal based on a comparison result between the diagnostic data and a predefined condition threshold.

According to an embodiment, the condition threshold may include a fixed condition threshold value provided as a fixed value of a predetermined size based on diagnostic data of at least one battery cell which is input to a predefined diagnosis algorithm.

According to another embodiment, the condition threshold may include a variable condition threshold that is dynamically adjusted over time based on diagnostic data of at least one normal battery cell.

Here, the variable condition threshold may be calculated according to any one of average, variance, and standard deviation based on diagnostic data of at least one normal battery cell.

According to another aspect of the present disclosure, an apparatus according to claim 6 is provided.

The at least one instruction may further include an instruction to correct the generated diagnostic data using a low pass filter (LPF).

The at least one instruction may further include an instruction to determine whether the battery cell is abnormal based on a comparison result between the diagnostic data and a predefined condition threshold.

According to an embodiment, the condition threshold may include a fixed condition threshold value provided as a fixed value of a predetermined size based on diagnostic data of at least one battery cell which is input to a predefined diagnosis algorithm.

According to another embodiment, the condition threshold may include a variable condition threshold that is dynamically adjusted over time based on diagnostic data of at least one normal battery cell.

Here, the variable condition threshold may be calculated according to any one of average, variance, and standard deviation based on diagnostic data of at least one normal battery cell.

### [Advantageous Effects]

An apparatus and method for diagnosing an abnormality of a battery cell according to embodiments of the present invention may obtain measurement data for at least one parameter of a battery cell, extract a signal of specific frequency bands from the measurement data to generate diagnostic data, and applying the generated diagnostic data to a predefined diagnosis algorithm to determine whether the battery cell has an abnormality, and thus, a noise signal can be improved, thereby accurately and reliably diagnosing whether the battery cell has an abnormality.

### [Brief Description of the Drawings]

FIG. 1 is a reference diagram for explaining a conventional method for diagnosing an abnormality of a battery cell.
FIG. 2 is a hardware block diagram of an apparatus for diagnosing an abnormality of a battery cell according to embodiments of the present invention.
FIG. 3 is a flowchart illustrating a method for diagnosing an abnormality of a battery cell according to embodiments of the present invention.
FIG. 4 is a diagram for explaining a process of generating diagnostic data according to embodiments of the present invention.
FIG. 5 is a diagram for explaining measurement data and diagnostic data according to embodiments of the present invention.
FIG. 6 is a diagram for explaining a method for diagnosing an abnormality of a battery cell using a variable condition threshold according to embodiments of the present invention.

1000: apparatus for diagnosing abnormality of battery cell
100: memory
200: processor
300: transceiver
400: input interface
500: output interface
600: storage device
700: Bus
T: variable condition threshold

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the scope of the claims.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

Terms used in the present application are used only to describe specific embodiments, and are not intended to limit the present invention. A singular form includes a plural form if there is no clearly opposite meaning in the context. In the present application, it should be understood that the term "include" or "have" indicates that a feature, a number, a step, an operation, a component, a part or the combination thereof described in the specification is present, but does not exclude a possibility of presence or addition of one or more other features, numbers, steps, operations, components, parts or combinations thereof, in advance.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Hereinafter, exemplary embodiments of the present invention will be described in detail with reference to the accompanying drawings.

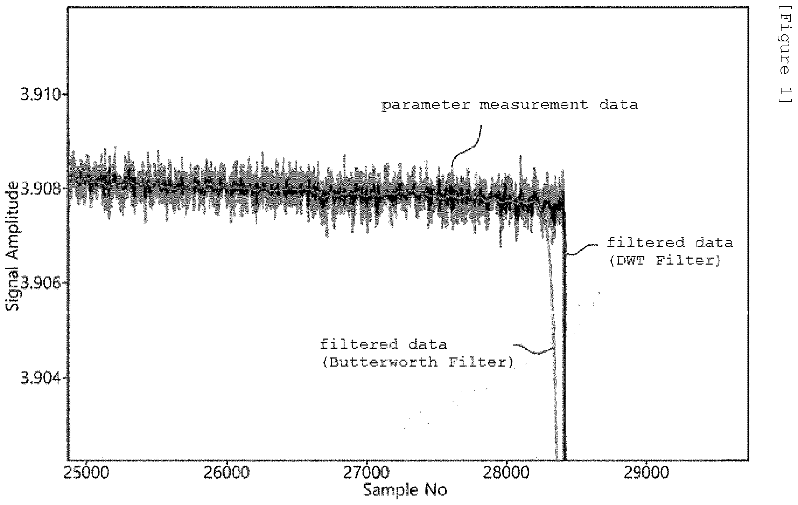

FIG. 1 is a reference diagram for explaining a general method for diagnosing an abnormality of a battery cell.

Referring to FIG. 1, a general apparatus for diagnosing a battery cell abnormality diagnoses whether a battery cell is abnormal using measurement data for a specific parameter of a battery cell from which noise is removed by filtering.

More specifically, a general apparatus for diagnosing an abnormality of a battery cell removes a specific noise signal from measurement data for a specific parameter obtained from a battery cell using a predefined filter. For example, the predefined filter may be a low pass filter. Thereafter, a general apparatus for diagnosing an abnormality of a battery cell inputs the parameter data from which specific noise has been removed to a predefined diagnosis algorithm to determine whether the battery cell is abnormal.

However, in a general apparatus for diagnosing an abnormality of a battery cell that removes a specific noise signal using a predefined filter, when diagnosing an abnormality in a battery cell applied to an electric vehicle, the reliability of diagnosis result may be deteriorated.

More specifically, in general, an electric vehicle may be exposed to various environments while being driven. Accordingly, when measuring a parameter of a battery cell in an electric vehicle, measurement data may include various noise signals.

However, since a general apparatus for diagnosing an abnormality of a battery cell selects and removes only a specific noise signal using a predefined filter, a diagnosis result may show low reliability due to noise that is not removed.

Meanwhile, an apparatus for diagnosing an abnormality in a battery cell according to embodiments of the present invention may select diagnostic data of specific frequency bands that frequently appears in measurement data obtained from the battery cell and apply it to a diagnosis algorithm, thereby more accurately determining an abnormality of a battery cell applied in an elecric vehicle. Hereinafter, an apparatus and method for diagnosing an abnormality of a battery cell according to embodiments of the present invention will be described in more detail with reference to the drawings.

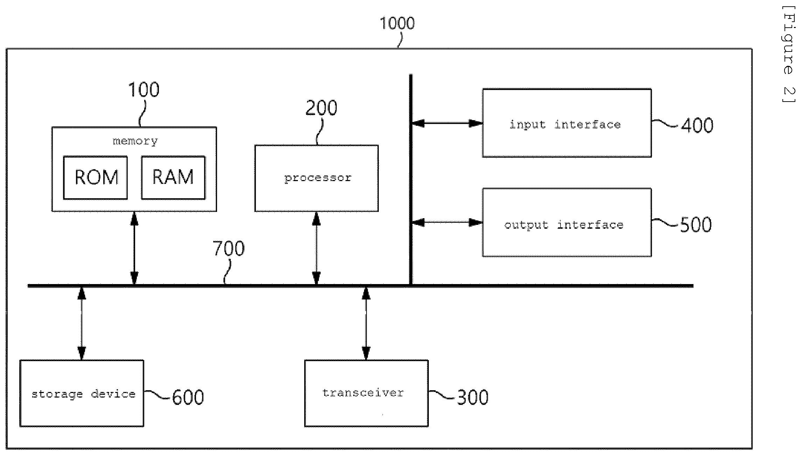

FIG. 2 is a hardware block diagram of an apparatus for diagnosing an abnormality of a battery cell according to embodiments of the present invention.

The apparatus 1000 for diagnosing an abnormality of a battery cell may diagnose whether a battery cell is abnormal. For example, the apparatus 1000 for diagnosing an abnormality of a battery cell may diagnose whether a battery cell applied to an electric vehicle has an abnormality. According to an embodiment, the apparatus 1000 for diagnosing an abnormality of a battery cell may acquire measurement data for at least one parameter of the battery cell, generate diagnostic data based on the obtained measurement data, and apply the diagnostic data to a diagnosis algorithm, so as to diagnose whether or not an abnormality has occurred in the battery cell.

Describing a hardware configuration of the apparatus 1000 for diagnosing an abnormality of a battery cell in more detail with referenc to Fig. 2, the apparatus 1000 for diagnosing an abnormality of a battery cell may include a memory 100, a processor 200, a transceiver 300, an input interface 400, an output interface 500, and a storage device 600.

According to an embodiment, each of the components 100, 200, 300, 400, 500, and 600 included in the apparatus 1000 for diagnosing an abnormality of a battery cell may be connected by a bus 700 to communicate with each other.

Among the components 100, 200, 300, 400, 500, and 600 of the apparatus 1000 for diagnosing an abnormality of a battery cell, the memory 100 and the storage device 600 may be composed of at least one of a volatile storage medium and a non-volatile storage medium. For example, the memory 100 and the storage device 600 may include at least one of a read only memory (ROM) and a random access memory (RAM).

The memory 100 may include at least one instruction executed by the processor 200.

According to an embodiment, the at least one instruction may include an instruction to obtain measurement data for at least one parameter of the battery cell; an instruction to generate diagnostic data by extracting a signal of a specific frequency band from the measurement data; and an instruction to determine whether the battery cell has an abnormality by applying the generated diagnostic data to a predefined diagnosis algorithm.

The processor 200 may mean a central processing unit (CPU), a graphics processing unit (GPU), or a dedicated processor on which methods according to embodiments of the present invention are performed.

As described above, the processor 200 may execute at least one program instruction stored in the memory 100.

In the above, an apparatus for diagnosing an abnormality of a battery cell according to embodiments of the present invention has been described. Hereinafter, a method of diagnosing whether a battery cell abnormality has occurred according to operations of a processor in an apparatus for diagnosing an abnormality of a battery cell will be described in more detail.

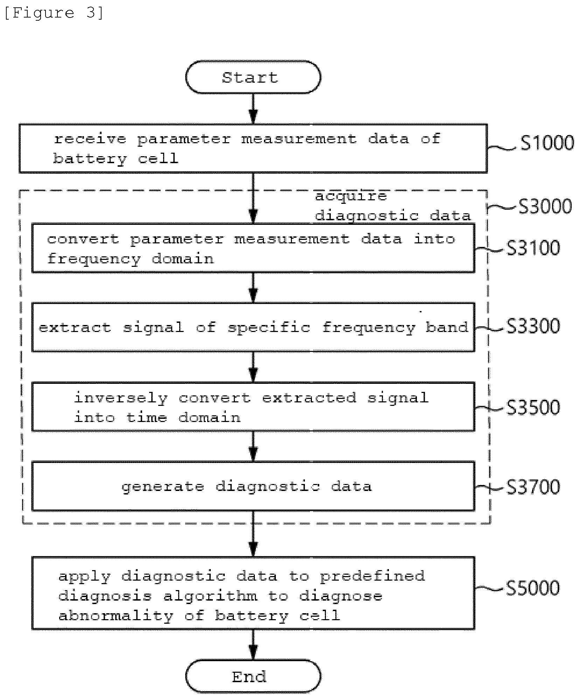

FIG. 3 is a flowchart illustrating a method for diagnosing an abnormality of a battery cell according to embodiments of the present invention.

Referring to FIG. 3 , the apparatus 1000 for diagnosing an abnormality of a battery cell may acquire measurement data for at least one parameter of the battery cell (S1000).

According to an embodiment, the measurement data may be data measured per unit time for at least one parameter of the battery cell. For example, the at least one parameter may be voltage or current. However, the types of parameters are not limited to those disclosed.

The apparatus 1000 for diagnosing an abnormality of a battery cell may receive measurement data from a parameter measuring device (not shown). For example, the apparatus 1000 for diagnosing an abnormality of a battery cell may receive voltage measurement data including a voltage value per unit time from a voltage measuring device.

Thereafter, the apparatus 1000 for diagnosing an abnormality of a battery cell may process the received parameter measurement data according to a predefined pre-processing algorithm (S3100 to S3700) to acquire diagnostic data for diagnosing battery cell abnormalities (S3000).

The apparatus 1000 for diagnosing an abnormality of a battery cell may diagnose whether a battery cell is abnormal by applying the generated diagnostic data to a predefined diagnosis algorithm (S5000).

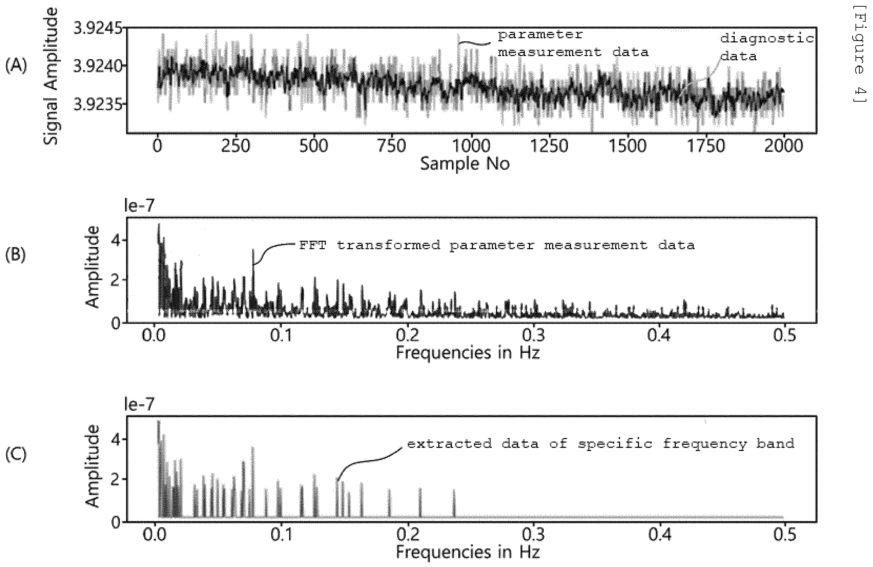

In FIG. 4, a method of acquiring diagnostic data from parameter measurement data of a battery cell according to embodiments of the present invention will be described in more detail.

FIG. 4 is a diagram for explaining a process of generating diagnostic data according to embodiments of the present invention. Meanwhile, in the following description, a parameter for diagnosis corresponding to voltage will be described as an example, but the scope of the present invention is not intended to be limited thereto.

More specifically, (A) of FIG. 4 is a graph (in time domain) showing voltage measurement data for a certain period of time and diagnostic data obtained from the voltage measurement data, (B) of FIG. 4 is a graph (in frequency domain) showing fast Fourier transformed voltage measurement data, FIG. 4(C) is a graph (in frequency domain) showing diagnostic data.

Referring to FIG. 4, the apparatus 1000 for diagnosing abnormality of a battery cell may generate diagnostic data by pre-processing measurement data (S3000). Here, the diagnostic data may be data to be input to a predefined diagnosis algorithm, so as to diagnose whether a battery cell has an abnormality.

A diagnosis algorithm according to an embodiment of the present invention may calculate a difference, variance, deviation, etc. between voltage measurement values of battery cells based on diagnostic data for each of a plurality of battery cells, and use the calculated values to determine whether an abnormality occurs in a specific battery cell or when the abnormality occurs. For another example, the diagnosis algorithm according to the present invention may compare the diagnostic data of a battery cell with a predefined condition threshold and may determine whether or not the corresponding battery cell is abnormal or not and when the abnormality occurs based on the comparison result (e.g., whether or not it exceeds the threshold).

To explain the process of generating diagnostic data in more detail, the apparatus 1000 for diagnosing an abnormality of a battery cell may convert measurement data into frequency domain data (S3100). For example, when the measurement data is voltage measurement data of a battery cell, the apparatus 1000 for diagnosing an abnormality of a battery cell may convert voltage measurement data including voltage values per predetermined unit of time ((A) in FIG. 4) into a frequency domain data ((B) in FIG. 4) by Fast Fourier Transform(FFT)ing the voltage measurement data.

Thereafter, the apparatus 1000 for diagnosing an abnormality of a battery cell may extract a signal of at least one specific frequency band that meets a predefined standard from the parameter measurement data which has been converted into a frequency domain data (S3300).

According to an embodiment, the apparatus 1000 for diagnosing an abnormality of a battery cell may extract a signal of at least one specific frequency band from measurement data (frequency domain) based on an appearance frequency count for each frequency band. For example, the apparatus 1000 for diagnosing an abnormality of a battery cell may calculate an appearance frequency count for each frequency band of measurement data (frequency domain), and extract a signal of top n (e.g., n = 20) frequency bands in terms of the appearance frequency count ((C) in FIG. 4), wherein n is preset natural number.

Thereafter, the apparatus 1000 for diagnosing an abnormality of a battery cell may generate diagnostic data (FIG. 4(A)) (S3700) by inversely converting the signal of the extracted at least one frequency band into time domain data (S3500).

According to an embodiment, the apparatus 1000 for diagnosing an abnormality of a battery cell may correct the diagnostic data by applying a predefined filter to the generated diagnostic data. For example, the apparatus 1000 for diagnosing an abnormality of a battery cell may apply a low pass filter (LPF) to diagnostic data, wherein the low pass filter (LPF) may be a Discrete Wavelet Transform (DWT) filter or a Butterworth Filter.

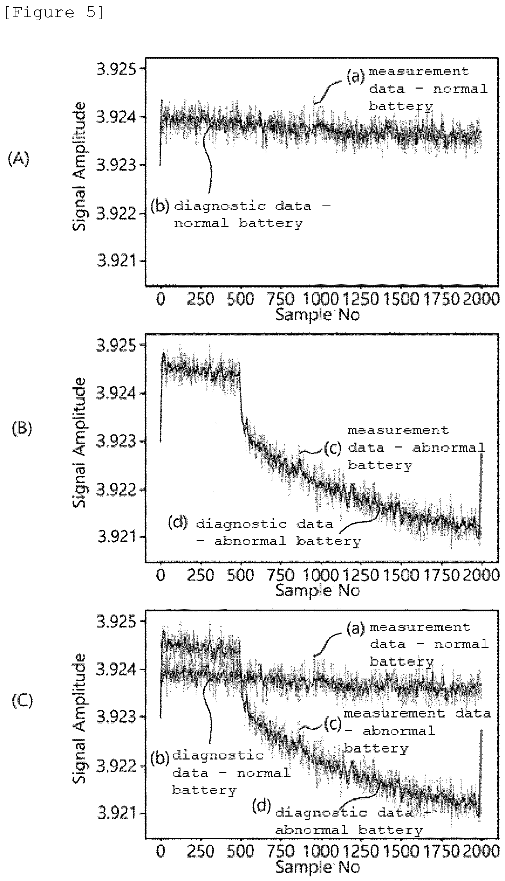

FIG. 5 is a diagram for explaining measurement data and diagnostic data according to embodiments of the present invention.

Referring to FIG. 5, (A) is a graph showing measurement data (voltage, (a)) of a normal battery cell and diagnostic data (b) generated based on the measurement data (a) and (B) is a graph showing measurement data (voltage, (c)) of an abnormal battery cell and diagnostic data (d) generated based on the measurement data (c). Further, (C) is a graph showing measurement data ((a), (c)) and diagnostic data ((b), (d)) in (A) and (B) together.

Referring to FIG. 5, the measurement data and diagnostic data of a normal battery in which no abnormality is found in the battery cell appear that the amplitude of cell voltage shows a horizontal form of graph ((a), (b)). On the other hand, the measurement data and diagnostic data of an abnormal battery in which abnormality is found in the battery cell shows a form of a graph ((c), (d)) in which the amplitude of cell voltage rapidly decreases, as shown in FIG. 5(B).

Here, referring to (C) of FIG. 5, it shows that measurement data (a) and measurement data (c) overlap each other in a section of sample 0 to 500.

On the other hand, diagnostic data (b) and diagnostic data (d) according to embodiments of the present invention do not overlap each other in the section of sample 0 to 500 since noise caused by movement of a transportation is improved.

Thereafter, the apparatus 1000 for diagnosing an abnormality of the battery cell may diagnose whether the battery cell is abnormal by applying the diagnostic data generated based on the measured data to a predefined diagnosis algorithm (S5000).

The diagnosis algorithm according to embodiments of the present invention may compare the diagnostic data of the battery cell with a predefined condition threshold (Threshold, T) and may determine whether or not the corresponding battery cell is abnormal or when the abnormality occurs based on the comparison result (e.g., whether the diagnostic data exceeds the threshold).

Here, condition threshold value T is a value that may be defined in the diagnosis algorithm and may function as a criterion for determining whether an abnormality of the battery cell has occurred. For example, the apparatus 1000 for diagnosing an abnormality in a battery cell may determine that the battery cell is normal if the magnitude of the voltage value included in the diagnostic data does not exceed the condition threshold value and may determine that an error has occurred in the cell from the corresponding time point if the magnitude of the voltage value exceeds the condition threshold value. For another example, the apparatus 1000 for diagnosing an abnormality of a battery cell may determine that the battery cell is normal when the magnitude of the voltage value included in the diagnostic data does not deviate from a predetermined range based on the condition threshold value and may determine that an error has occurred in the battery cell from the corresponding time point if the magnitude of the voltage value is out of the predetermined range based on the condition threshold value (T).

According to an embodiment, the condition threshold may include a fixed condition threshold provided as a fixed value of a predetermined size. In other words, the fixed condition threshold may be set to a fixed value of a predetermined size by a user based on diagnostic data of a specific battery cell input to a predefined diagnosis algorithm.

According to another embodiment, the condition threshold value may be provided as a variable condition threshold value that is dynamically set over time based on pre-obtained diagnostic data.

More specifically, the variable condition threshold value may include a variable condition threshold value that is dynamically calculated based on previously obtained diagnostic data of at least one normal battery cell over time. In other words, the variable condition threshold value may be dynamically adjusted over time based on at least one diagnostic data obtained over time for at least one battery cell that is determined to be normal through a predefined diagnosis algorithm.

For example, the variable condition threshold may be a value that is proportion to an calculated average value of diagnostic data which is collected over time of at least one battery cell that is determined to be normal by the diagnosis algorithm. However, without being limited to the disclosed embodiments, the variable condition threshold may be calculated and applied as any one of increase/decrease, average, variance, or standard deviation, or a combination of two or more, based on diagnostic data of normal battery cells over time.

As described above, the variable condition threshold may be applied based on noise-removed diagnostic data. Accordingly, when detecting an abnormality of a specific battery cell using the diagnosis algorithm, overlapping of the diagnostic data of the battery cell and the variable condition threshold value due to noise is prevented, and thus, highly reliable diagnosis can be made.

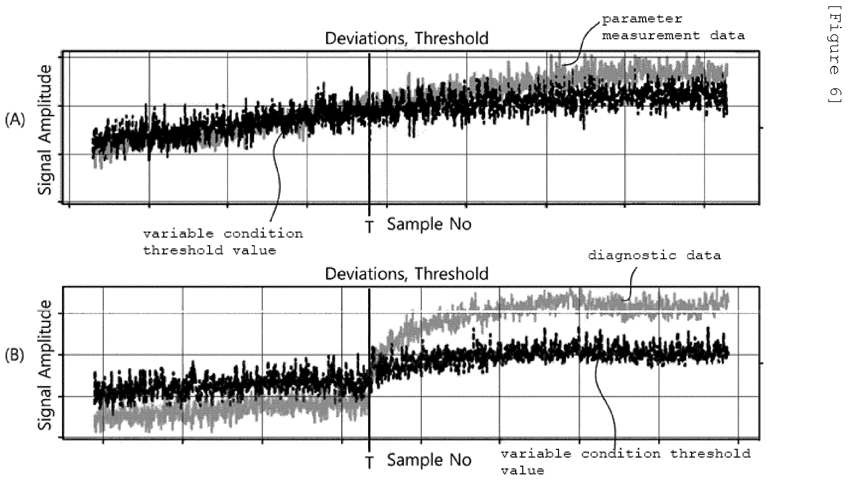

FIG. 6 is a diagram for explaining a method for diagnosing an abnormality of a battery cell using a variable condition threshold according to embodiments of the present invention. More specifically, FIG. 6(A) is a graph showing battery cell measurement data and variable condition threshold values together, and FIG. 6(B) is a graph showing diagnostic data and variable condition threshold values together.

As shown in (A) of FIG. 6, when using a method of determining an abnormality of a battery cell in which measurement data from which noise is not removed is input to a diagnosis algorithm and compares the measured data with a variable condition threshold value, multiple overlapping sections appear, thereby making accurate diagnosis difficult.

On the other hand, as shown in (B) of FIG. 6, according to an embodiment of the present invention, when the diagnostic data from which noise has been removed is input to the diagnosis algorithm to determine whether the battery cell is abnormal, the difference between the diagnostic data and the variable condition threshold value is clearly shown, so that it is possible to more accurately determine whether or not the battery cell is abnormal.

The apparatus and method for diagnosing an abnormality of a battery cell according to embodiments of the present invention have been described above.

An apparatus and method for diagnosing an abnormality of a battery cell according to embodiments of the present invention may obtain measurement data for at least one parameter of a battery cell, extract a signal of specific frequency bands from the measurement data to generate diagnostic data, and applying the generated diagnostic data to a predefined diagnosis algorithm to determine whether the battery cell has an abnormality, and thus, a noise signal can be improved, thereby accurately and reliably diagnosing whether the battery cell has an abnormality.

The operations of the method according to the embodiments and experimental embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

In addition, the computer-readable recording medium may include hardware devices specially configured to store and execute program instructions, such as ROM, RAM, and flash memory. The program instruction may include high-level language codes that can be executed by a computer using an interpreter or the like as well as machine codes generated by a compiler.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiments of the present invention, but those skilled in the art may appreciate that the present invention may be variously corrected and changed within the range without departing from the scope of the present invention described in the appending claims.

## Claims

1. A method of diagnosing an abnormality of a battery cell, the method comprising:
obtaining (S1000) measurement data for at least one parameter of the battery cell;
generating (S3000) diagnostic data by extracting a signal of a specific frequency band from the measurement data; and
determining whether the battery cell has an abnormality by applying (S5000) the generated diagnostic data to a predefined diagnosis algorithm wherein the generating (S3000) diagnostic data includes:
converting (S3100) the measurement data into frequency domain data;
the method **characterised by**:
calculating an appearance frequency count for each frequency band of the converted frequency domain data;
extracting (S3300) a signal of top N frequency bands with regard to the appearance frequency count, wherein N is a predetermined natural number; and
inversely (S3500) transforming the extracted signal into time domain data to generate diagnostic data.

2. The method of claim 1, further comprising correcting the generated diagnostic data using a low pass filter, LPF.

3. The method of claim 1, wherein the determining (S5000) whether the battery cell has an abnormality includes determining whether the battery cell is abnormal based on a comparison result between the diagnostic data and a predefined condition threshold.

4. The method of claim 3, wherein the condition threshold includes a fixed condition threshold value provided as a fixed value of a predetermined size based on diagnostic data of at least one battery cell which is input to a predefined diagnosis algorithm.

5. The method of claim 3, wherein the condition threshold includes a variable condition threshold that is dynamically adjusted over time based on diagnostic data of at least one normal battery cell,
wherein the variable condition threshold is calculated according to any one of average, variance, and standard deviation based on diagnostic data of at least one normal battery cell.

6. An apparatus (1000) for diagnosing an abnormality of a battery cell, the apparatus comprising:
at least one processor (200); and
a memory (600) configured to store at least one instruction executed by the at least one processor (200),
wherein the at least one instruction includes:
an instruction to obtain measurement data for at least one parameter of the battery cell;
an instruction to generate diagnostic data by extracting a signal of a specific frequency band from the measurement data; and
an instruction to determine whether the battery cell has an abnormality by applying the generated diagnostic data to a predefined diagnosis algorithm;
wherein the at least one instruction includes:
an instruction to convert the measurement data into frequency domain data;
**characterised by:**
an instruction to calculate an appearance frequency count for each frequency band of the converted frequency domain data;
an instruction to extract a signal of top N frequency bands with regard to the appearance frequency count, wherein N is a predetermined natural number; and
an instruction to inversely transform the extracted signal into time domain data to generate diagnostic data.

7. The apparatus (1000) of claim 6, wherein the at least one instruction further includes an instruction to determine whether the battery cell is abnormal based on a comparison result between the diagnostic data and a predefined condition threshold.

8. The apparatus (1000) of claim 7, wherein the condition threshold includes a fixed condition threshold value provided as a fixed value of a predetermined size based on diagnostic data of at least one battery cell which is input to a predefined diagnosis algorithm.

9. The apparatus (1000) of claim 7, wherein the condition threshold includes a variable condition threshold that is dynamically adjusted over time based on diagnostic data of at least one normal battery cell, and
wherein the variable condition threshold is calculated according to any one of average, variance, and standard deviation based on diagnostic data of at least one normal battery cell.

## Patentansprüche

1. Verfahren zum Diagnostizieren einer Anomalie einer Batteriezelle, wobei das Verfahren umfasst:
Erhalten (S1000) von Messdaten für wenigstens einen Parameter der Batteriezelle;
Generieren (S3000) von diagnostischen Daten durch Extrahieren eines Signals eines spezifischen Frequenzbands aus den Messdaten; und
Bestimmen, ob die Batteriezelle eine Anomalie aufweist, durch Anwenden (S5000) der generierten diagnostischen Daten auf einen vordefinierten Diagnosealgorithmus,
wobei das Generieren (S3000) der diagnostischen Daten umfasst:
Konvertieren (S3100) der Messdaten in Frequenzbereichsdaten;
das Verfahren **gekennzeichnet durch**:
Berechnen einer Auftrittsfrequenzzählung für jedes Frequenzband der konvertierten Frequenzbereichsdaten;
Extrahieren (S3300) eines Signals von oberen N Frequenzbändern in Bezug auf die Auftrittsfrequenzzählung, wobei N eine vorbestimmte natürliche Zahl ist; und
inverses (S3500) Transformieren des extrahierten Signals in Zeitbereichsdaten, um diagnostische Daten zu generieren.

2. Verfahren nach Anspruch 1, ferner umfassend ein Korrigieren der generierten diagnostischen Daten durch Verwendung eines Tiefpassfilters, LPF.

3. Verfahren nach Anspruch 1, wobei das Bestimmen (S5000), ob die Batteriezelle eine Anomalie aufweist, ein Bestimmen umfasst, ob die Batteriezelle abnormal ist, basierend auf einem Vergleichsergebnis zwischen den diagnostischen Daten und einem vordefinierten Bedingungsschwellenwert.

4. Verfahren nach Anspruch 3, wobei der Bedingungsschwellenwert einen festen Bedingungsschwellenwert umfasst, welcher als ein fester Wert einer vorbestimmten Größe bereitgestellt ist, basierend auf diagnostischen Daten von wenigstens einer Batteriezelle, welche in einen vordefinierten Diagnosealgorithmus eingegeben werden.

5. Verfahren nach Anspruch 3, wobei der Bedingungsschwellenwert einen variablen Bedingungsschwellenwert umfasst, welcher dynamisch über eine Zeit basierend auf diagnostischen Daten von wenigstens einer normalen Batteriezelle angepasst wird,
wobei der variable Bedingungsschwellenwert gemäß einem aus Durchschnitt, Varianz und Standardabweichung basierend auf diagnostischen Daten von wenigstens einer normalen Batteriezelle berechnet wird.

6. Vorrichtung (1000) zum Diagnostizieren einer Anomalie einer Batteriezelle, die Vorrichtung umfassend:
wenigstens einen Prozessor (200); und
einen Speicher (600), welcher dazu eingerichtet ist, wenigstens eine Anweisung zu speichern, welche von dem wenigstens einen Prozessor (200) ausgeführt wird,
wobei die wenigstens eine Anweisung umfasst:
eine Anweisung zum Erhalten von Messdaten für wenigstens einen Parameter der Batteriezelle;
eine Anweisung zum Generieren von diagnostischen Daten durch Extrahieren eines Signals eines spezifischen Frequenzbands aus den Messdaten; und
eine Anweisung zum Bestimmen, ob die Batteriezelle eine Anomalie aufweist, durch Anwenden der generierten diagnostischen Daten auf einen vordefinierten Diagnosealgorithmus;
wobei die wenigstens eine Anweisung umfasst:
eine Anweisung zum Konvertieren der Messdaten in Frequenzbereichsdaten;
**gekennzeichnet durch**:
eine Anweisung zum Berechnen einer Auftrittsfrequenzzählung für jedes Frequenzband der konvertierten Frequenzbereichsdaten;
eine Anweisung zum Extrahieren eines Signals von oberen N Frequenzbänder in Bezug auf die Auftrittsfrequenzzählung, wobei N eine vorbestimmte natürliche Zahl ist; und
eine Anweisung zum inversen Transformieren des extrahierten Signals in Zeitbereichsdaten, um diagnostische Daten zu generieren.

7. Vorrichtung (1000) nach Anspruch 6, wobei die wenigstens eine Anweisung ferner eine Anweisung zum Bestimmen umfasst, ob die Batteriezelle abnormal ist, basierend auf einem Vergleichsergebnis zwischen den diagnostischen Daten und einem vordefinierten Bedingungsschwellenwert.

8. Vorrichtung (1000) nach Anspruch 7, wobei der Bedingungsschwellenwert einen festen Bedingungsschwellenwert umfasst, welcher als ein fester Wert einer vorbestimmten Größe bereitgestellt ist, basierend auf diagnostischen Daten von wenigstens einer Batteriezelle, welche in einen vordefinierten Diagnosealgorithmus eingegeben werden.

9. Vorrichtung (1000) nach Anspruch 7, wobei der Bedingungsschwellenwert einen variablen Bedingungsschwellenwert umfasst, welcher dynamisch über die Zeit basierend auf diagnostischen Daten von wenigstens einer normalen Batteriezelle angepasst wird, und
wobei der variable Bedingungsschwellenwert gemäß einem aus Durchschnitt, Varianz und Standardabweichung basierend auf diagnostischen Daten von wenigstens einer normalen Batteriezelle berechnet wird.

## Revendications

1. Procédé de diagnostic d'une anomalie d'un élément de batterie, le procédé comprenant :
l'obtention (S1000) de données de mesure pour au moins un paramètre de l'élément de batterie ;
la génération (S3000) de données de diagnostic en extrayant un signal d'une bande de fréquences spécifique à partir des données de mesure ; et
déterminer si l'élément de batterie présente une anomalie en appliquant (S5000) les données de diagnostic générées à un algorithme de diagnostic prédéfini, dans lequel la génération de données de diagnostic (S3000) inclut :
la conversion (S3100) des données de mesure en données de domaine fréquentiel ;
le procédé étant **caractérisé par** :
le calcul d'un nombre de fréquences d'apparition pour chaque bande de fréquences des données de domaine fréquentiel converties ;
l'extraction (S3300) d'un signal des N bandes de fréquences les plus élevées en fonction du nombre de fréquences d'apparition, N étant un nombre naturel prédéterminé ; et
la transformation inverse (S3500) du signal extrait en données de domaine temporel pour générer des données de diagnostic.

2. Procédé selon la revendication 1, comprenant en outre la correction des données de diagnostic générées à l'aide d'un filtre passe-bas, LPF.

3. Procédé selon la revendication 1, dans lequel la détermination (S5000) si l'élément de batterie présente une anomalie inclut la détermination si l'élément de batterie est anormal sur la base d'un résultat de comparaison entre les données de diagnostic et un seuil de condition prédéfini.

4. Procédé selon la revendication 3, dans lequel le seuil de condition inclut une valeur seuil de condition fixe fournie en tant que valeur fixe d'une taille prédéterminée sur la base de données de diagnostic d'au moins un élément de batterie qui sont entrées dans un algorithme de diagnostic prédéfini.

5. Procédé selon la revendication 3, dans lequel le seuil de condition inclut un seuil de condition variable qui est ajusté dynamiquement au fil du temps sur la base de données de diagnostic d'au moins un élément de batterie normal,
dans lequel le seuil de condition variable est calculé en fonction de l'un parmi la moyenne, la variance et l'écart-type sur la base de données de diagnostic d'au moins un élément de batterie normal.

6. Appareil (1000) de diagnostic d'une anomalie d'un élément de batterie, l'appareil comprenant :
au moins un processeur (200) ; et
une mémoire (600) configurée pour stocker au moins une instruction exécutée par l'au moins un processeur (200),
dans lequel l'au moins une instruction inclut :
une instruction pour obtenir des données de mesure concernant au moins un paramètre de l'élément de batterie ;
une instruction pour générer des données de diagnostic par extraction d'un signal d'une bande de fréquences spécifique à partir des données de mesure ; et
une instruction pour déterminer si l'élément de batterie présente une anomalie en appliquant les données de diagnostic générées à un algorithme de diagnostic prédéfini ;
dans lequel l'au moins une instruction inclut :
une instruction pour convertir des données de mesure en données de domaine fréquentiel ;
**caractérisé par** :
une instruction pour calculer un nombre de fréquences d'apparition pour chaque bande de fréquences des données de domaine fréquentiel converties ;
une instruction pour extraire un signal des N bandes de fréquence les plus élevées en fonction du nombre de fréquences d'apparition, où N est un nombre naturel prédéterminé ; et
une instruction pour transformer inversement le signal extrait en données de domaine temporel pour générer des données de diagnostic.

7. Appareil (1000) selon la revendication 6, dans lequel l'au moins une instruction inclut en outre une instruction pour déterminer si l'élément de batterie est anormal sur la base d'un résultat de comparaison entre les données de diagnostic et un seuil de condition prédéfini.

8. Appareil (1000) selon la revendication 7, dans lequel le seuil de condition inclut une valeur seuil de condition fixe fournie en tant que valeur fixe d'une taille prédéterminée sur la base de données de diagnostic d'au moins un élément de batterie qui sont entrées dans un algorithme de diagnostic prédéfini.

9. Appareil (1000) selon la revendication 7, dans lequel le seuil de condition inclut un seuil de condition variable qui est ajusté dynamiquement au fil du temps sur la base de données de diagnostic d'au moins un élément de batterie normal, et
dans lequel le seuil de condition variable est calculé en fonction de l'un parmi la moyenne, la variance et l'écart-type sur la base de données de diagnostic d'au moins un élément de batterie normal.
